# EUROPÄISCHE PATENTSCHRIFT

(11) **EP 1 205 005 B1**
(45) Veröffentlichungstag und Bekanntmachung des Hinweises auf die Patenterteilung: **02.05.2003**
(21) Anmeldenummer: 00952927.2
(22) Anmeldetag: 13.07.2000
(51) Int. Cl.: H01P 3/08, H01P 11/00

(54) **STREIFENLEITUNG FÜR MIKROWELLENANWENDUNGEN**
MICROSTRIP FOR MICROWAVE APPLICATIONS
MICROBANDE DESTINEE A DES APPLICATIONS MICRO-ONDES

(30) Priorität: 23.07.1999 DE 19934657; 25.08.1999 DE 19940163
(43) Veröffentlichungstag der Anmeldung: 15.05.2002
(73) Patentinhaber: Nagel, Michael, 41751 Viersen (DE)
(72) Erfinder: NAGEL, Michael, D-41751 Viersen (DE); DEKORSY, Thomas, D-52066 Aachen (DE); KURZ, Heinreich, D-52076 Aachen (DE)
(74) Vertreter: Tergau & Pohl Patentanwälte
(86) Internationale Anmeldenummer: DE0002283
(87) Internationale Veröffentlichungsnummer: WO01008251

(56) Entgegenhaltungen:
- EP-A- 0 369 408
- US-A- 4 916 009
- J.-P. RAMY ET AL.: "OPTIMIZATION OF THE THICK- AND THIN-FILM TECHNOLOGIES FOR MICROWAVE CIRCUITS ON ALUMINA AND FUSED SILICA SUBSTRATES" IEEE TRANSACTIONS ON MICROWAVE THEORY AND TECHNIQUES., Bd. 26, Nr. 10, Oktober 1978 (1978-10), Seiten 814-820, XP002150223 IEEE INC. NEW YORK., US ISSN: 0018-9480

## Beschreibung

Gegenstand der vorliegenden Erfindung ist eine Streifenleitung für Hochfrequenzanwendungen gemäss des Oberbegriffs des Hauptanspruchs.

Streifenleitungen für Hochfrequenzanwendungen im Mikrowellenbereich weisen einen charakteristischen Aufbau auf. Sie bestehen aus einer im allgemeinen flächenhaften Grundelektrode sowie einem im allgemeinen streifenförmigen Signalleiter, zwischen denen ein wiederum flächenhaftes oder streifenförmiges Dielektrikum angeordnet ist. Die Grundelektrode und der Signalleiter weisen eine hohe elektrische Leitfähigkeit auf, die beispielsweise durch Verwendung metallischer Leiter realisiert werden kann. Die Grundelektrode befindet sich typischerweise auf der Unterseite eines selbsttragenden Dielektrikums. Bei dünnen Dielektrika kann die Grundelektrode auf einem Substrat wie zum Beispiel einer Epoxidharz-Leiterplatte aufgebracht werden. Um eine möglichst geringe Dämpfung der gattungsgemässen Streifenleitung zu erzielen, ist unter anderem ein konstanter Abstand zwischen Grundelektrode und Signalleiter erforderlich. Bei der angegebenen Konstruktion wird dieser Abstand durch das Dielektrikum bestimmt, welches als Abstandshalter fungiert. Die dielektrischen Eigenschaften des Dielektrikums sind ebenfalls entscheidend für die Leitungseigenschaften einer gattungsgemässen Streifenleitung.

Aus der US 5,745,984 ist eine Streifenleitung für Mikrowellenanwendungen bekannt, die als Dielektrikum eine dünne Benzocyclobuten-Basis (BCB) Schicht verwendet, die auf ein Substrat aufgeschleudert wird, und auf die ein Kapton-Polymid-Film aufgelegt wird. Dieses Schichtsystem wird unter Druck bei Temperaturen von etwa 200°C ausgehärtet. Auf die genannte Art und Weise ist es möglich, ein Dielektrikum mit gleichmässiger Dicke im Bereich zwischen 35 und 65 µm auf einem Substrat zu deponieren. Jedoch treten im dielektrischen Schichtsystem nach dem Aushärten Materialspannungen auf, die die Haftung verschlechtern. Zusätzlich nimmt das Aushärten der BCB-Schicht mehr als eine Stunde in Anspruch.

Weiterhin ist aus der US 5,155,493 eine Streifenleitung für Mikrowellenanwendungen bekannt, die aus einer metallischen Grundelektrode in Form einer einseitig selbstklebend beschichteten Metallfolie, einem Dielektrikum in Form einer ebenfalls einseitig selbstklebend beschichteten dielektrischen Folie sowie einem metallischen Signalleiter wiederum in Form einer einseitig selbstklebend beschichteten Metallfolie besteht. Als Dielektrikum wird PTFE (Teflon) vorgeschlagen. Genaue Angaben zu Schichtdicken sind nicht gemacht. Die Verwendung von Teflon als Dielektrikum weist einerseits Kostennachteile auf, da es verhältnismässig teuer ist, andererseits auch technische Nachteile, da es eine ungünstigere relative Dielektrizitätskonstante aufweist. Weiterhin ergeben sich Probleme bei einer Verklebung der Streifenleitung, da auf Teflon nur eine geringe Haftwirkung zu erzielen ist.

Aufgabe der vorliegenden Erfindung ist es daher, eine Streifenleitung für Hochfrequenzanwendungen insbesondere im Millimeterwellenbereich anzugeben, die einen besonders einfachen Aufbau aufweist, zu geringen Kosten zu fertigen ist und technische Vorteile aufweist sowohl bezüglich der Haltbarkeit als auch bezüglich der Übertragungseigenschaften.

Gelöst wird diese Aufgabe durch eine Streifenleitung für Hochfrequenzanwendungen mit den Merkmalen des Hauptanspruchs. Eine solche Streifenleitung verwendet einen relaxierten Polymerfilm als Dielektrikum. Unter "relaxiert" soll in diesem Zusammenhang verstanden werden, dass während des Fertigungsprozesses des Polymerfilms auftretende innere Spannungen bereits während des Produktionsprozesses des Polymerfilms beseitigt werden, d. h., dass der Polymerfilm bereits weitgehend in seinen thermodynamischen Endzustand relaxiert ist. Ein solcher relaxierter Zustand kann beispielsweise durch thermische Behandlung erzielt werden, weiterhin auch durch einen kontrollierten Streckungsprozess. Der aus einem solchen Streckungsprozess resultierende Polymerfilm wird als vorgereckt bezeichnet.

Eine erfindungsgemässe Streifenleitung für Hochfrequenzanwendungen ist besonders einfach herzustellen. Auf ein metallisiertes Substrat, beispielsweise eine galvanisch metallbeschichtete Epoxydharz-Leiterplatte wird das einseitig selbstklebend beschichtete Dielektrikum aufgeklebt. Das Dielektrikum kann vorteilhaft gebrauchsfertig vorkonfektioniert und insbesondere auf einer Rolle aufgespult sein. Dabei weist es bevorzugt einen bandförmigen Zuschnitt auf. Die Breite des Bandes wird passend für die zu realisierende Mikrowellenanwendung gewählt. Die Dicke des Bandes wird angepasst an die Mikrowellenfrequenz gewählt. Nach der Aufbringung des Bandes kann dieses am Substratrand zum Beispiel mit einer heißen Klinge abgeschnitten werden. Ebenfalls ist eine der Substratform angepasste Vorkonfektionierung des Dielektrikums möglich, wodurch eine präzisere Kantenverklebung erreichbar ist. Anschließend wird mittels eines geeigneten Verfahrens die metallische Signalelektrode auf die Oberseite des Dielektrikums aufgebracht, beispielsweise durch thermisches Aufdampfen.

Die erfindungsgemäße Streifenleitung für Hochfrequenzanwendungen weist besonders günstige Übertragungseigenschaften im Millimeterwellenbereich auf, wenn das dielektrische Schichtsystem bestehend aus dem Dielektrikum und der darauf aufgebrachten Selbstklebeschicht im Frequenzbereich zwischen 500 MHz und 1 THz, insbesondere im Frequenzbereich zwischen 1 GHz und 500 GHz eine relative Dielektrizitätskonstante εᵣ von kleiner als 2,5 aufweist. Vorzugsweise weist das dielektrische Schichtsystem eine relative Dielektrizitätskonstante von kleiner als 2,4 auf.

Für Millimeterwellenanwendungen hat sich als besonders günstig herausgestellt, wenn das für die erfindungsgemässe Streifenleitung verwendete Dielektrikum, insbesondere aber das dielektrische Schichtsystem aus Dielektrikum und Selbstklebeschicht eine mittlere Dicke zwischen 25 µm und 75 µm aufweist. Vorzugsweise beträgt seine Dicke 50 µm. Eine besonders geringe Dämpfung der erfindungsgemässen Streifenleitung ergibt sich, wenn die Dickenschwankungen δd des Dielektrikums, insbesondere aber des dielektrischen Schichtsystems aus Dielektrikum und Selbstklebeschicht in Abschnitten der Streifenleitung, die durch eine konstante mittlere Dicke d gekennzeichnet sind, kleiner sind als 5 %, vorzugsweise kleiner sind als 2 % und insbesondere kleiner sind als 1 % der mittleren Dicke d.

Besondere Vorteile ergeben sich, wenn als Dielektrikum für die erfindungsgemässe Streifenleitung Polypropylen verwendet wird. Polypropylen weist einerseits die geforderten dielektrischen Eigenschaften auf und ist andererseits problemlos während des Produktionsprozesses einer solchen Behandlung zu unterwerfen, dass die geforderten Eigenschaften bezüglich der Genauigkeit seiner Dicke und vor allem seiner Spannungsfreiheit erfüllt werden können. Insbesondere kann Polypropylen mittels eines Streckungsprozesses in den geforderten relaxierten Zustand gebracht werden. Weiterhin ist Polypropylen besonders kostengünstig herzustellen.

Für die erfindüngsgemässe Selbstklebeschicht auf dem Dielektrikum hat sich eine Beschichtung aus Acrylat Co-Polymer besonders bewährt.

Vorteilhafterweise besteht die Kombination aus einem Polypropylenfilm, der einseitig mit einer Selbstklebeschicht aus Acrylat Co-Polymer beschichtet ist bereits kommerziell in Form des von der Firma Beiersdorf vertriebenen Tesa-Films zur Verfügung.

Sowohl die metallische Grundelektrode als auch der metallische Signalleiter können thermisch oder mittels Elektronenstrahlverdampfung aufgedampft, galvanisch abgeschieden oder aufgesputtert sein. Weiterhin ist es möglich, sowohl die metallische Grundelektrode als auch den metallischen Signalleiter aus einer selbstklebend beschichteten Metallfolie herzustellen. Sowohl der metallische Signalleiter als auch die metallische Grundelektrode der erfindungsgemässen Streifenleitung können mittels gängiger Lithographietechniken strukturiert sein. Daraus ergibt sich die Möglichkeit, mittels einer erfindungsgemässen Streifenleitung passive Mikrowellenbauelemente die beispielsweise einen Leitungsknick, eine Leiterbreitenstufe, einen Lcitungsleerlauf, einen Leitungskurzschluss, einen Filter oder eine Antenne zu bilden.

Weitere Merkmale und Vorteile der erfindungsgemässen Streifenleitung ergeben sich aus den Unteransprüchen sowie den nachfolgenden Ausführungsbeispielen, die anhand der Abbildung diskutiert werden. In dieser zeigen:
- Fig. 1:: einen Querschnitt durch eine erfindungsgemässe Streifenleitung aufgebracht auf eine Epoxidleiterplatte,
- Fig. 2:: eine perspektivische Ansicht desselben Streifenleiters,
- Fig. 3:: eine graphische Darstellung vergleichender Messungen an einem Streifenleiter mit Dielektrikum aus BCB und einem Streifenleiter mit Dielektrikum aus einem Polypropylenfilm, und
- Fig. 4:: eine schematische Darstellung einer Vorrichtung zum Abrollen und Aufwalzen des bandförmigen Dielektrikums.

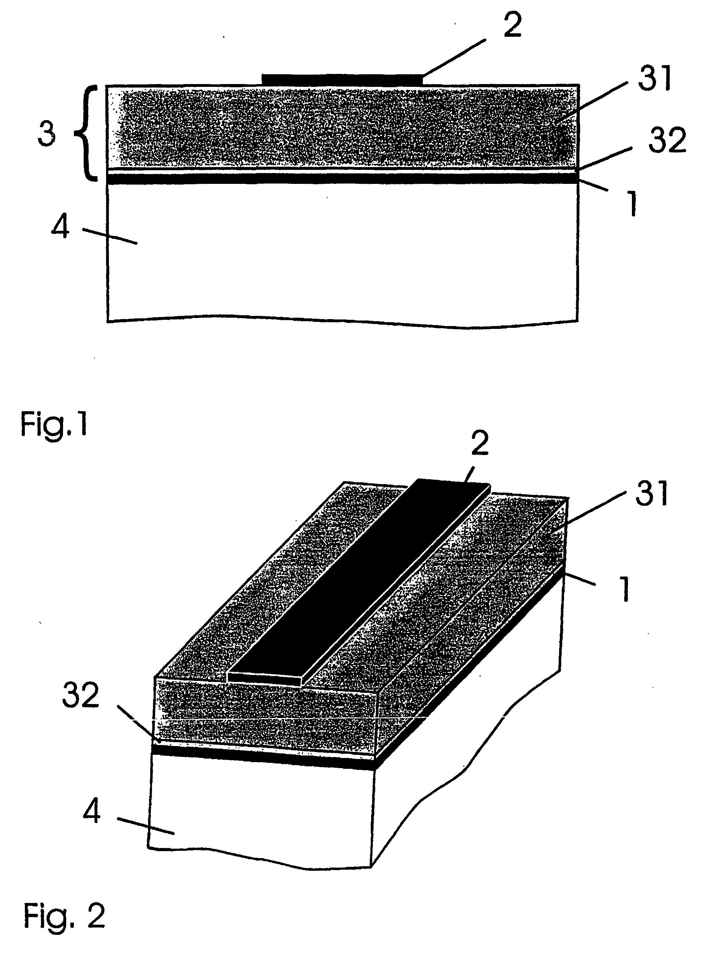

In Figur 1 ist der grundsätzliche Aufbau einer erfindungsgemässen Streifenleitung gezeigt. Auf eine Epoxidleiterplatte 4 ist eine Metallschicht galvanisch abgeschieden, welche die metallische Grundelektrode 1 bildet. Ihre Dicke beträgt typisch einige zig Nanometer bis mehrere µm. Auf diese metallische Grundelektrode 1 ist das Dielektrikum 3 aufgebracht, welches von dem dielektrischen Schichtsystem bestehend aus einem relaxierten Polymerfilm 31, der einseitig mit einer Selbstklebeschicht 32 versehen ist, gebildet wird.

Dabei besteht der relaxierte Polymerfilm aus Polypropylen und weist eine Dicke von 52 µm auf. Die Selbstklebeschicht 32 besteht aus Acrylat Co-Polymer und weist eine Dicke von etwa 5 µm auf.

Auf die Oberseite des relaxierten Polymerfilms 31 ist ein metallischer Signalleiter 2 aufgedampft. Die Dicke des Signalleiters 2 wird dergestalt gewählt, dass sich metallische Leitungseigenschaften im metallischen Signalleiter ausbilden. Die aufgebrachte Dicke des metallischen Signalleiters 2 beträgt wiederum mindestens einige nm bis zu einigen µm. Hierbei sind alle Metalle geeignet, die im fraglichen Frequenzbereich eine gute elektrische Leitfähigkeit aufweisen. Jedoch ist auch die Verwendung weiterer Materialien zur Erstellung des metallischen Signalleiters 2 denkbar, sofern diese eine ausreichende elektrische Leitfähigkeit aufweisen. Beispielhaft seien an dieser Stelle elektrisch leitfähige Polymere genannt. Vergleichbares gilt auch für die metallische Grundelektrode 1. Als Verfahren zur Aufbringung der metallischen Grundelektrode 1 sowie des metallischen Signalleiters 2 kommen alle Arten von Bedampfungsverfahren in Betracht, beispielsweise thermisches Verdampfen oder Elektronenstrahlverdampfen, Sputterprozesse oder galvanisches Abscheiden. Die so aufgebrachten Metallelektroden können mittels gängiger Lithographieverfahren strukturiert werden. Zu nennen sind hier beispielsweise photolithographische Verfahren sowie Elektronenstrahllithographie, gefolgt jeweils von geeigneten Ätzverfahren.

Die perspektivische Figur 2 verdeutlicht nochmals die geometrischen Verhältnisse einer erfindungsgemässen Streifenleitung. Insbesondere ist aus ihr die Geometrie eines streifenförmigen Signalleiters 2 ersichtlich.

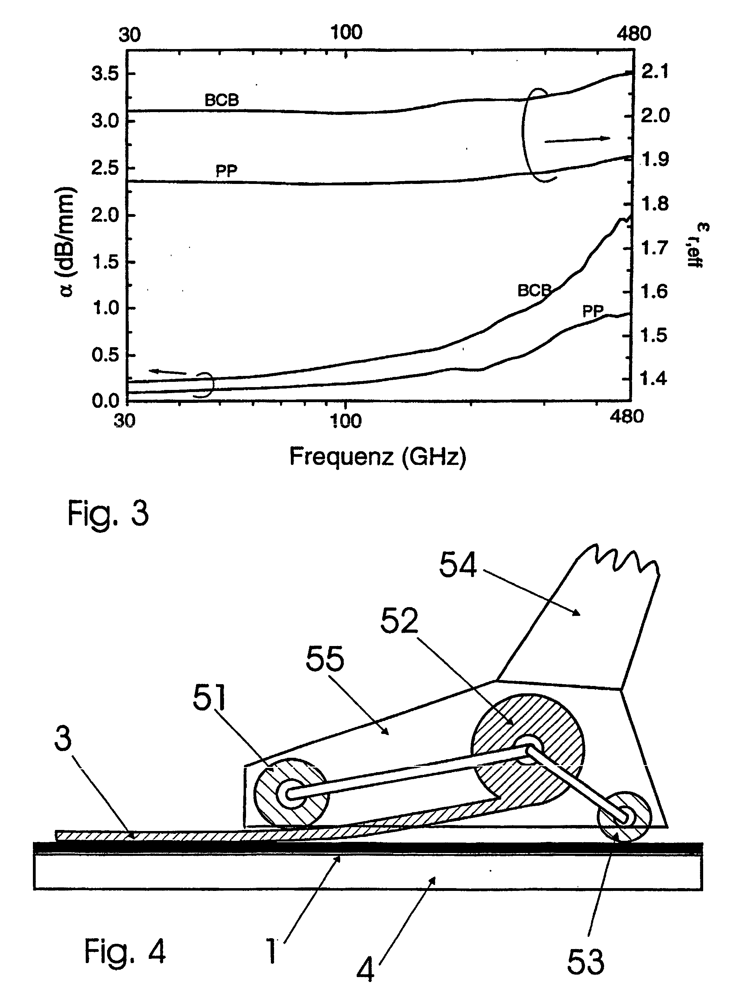

Aus Figur 3 sind die Ergebnisse einer Vergleichsmessung an zwei Streifenleitungen im Millimeterwellenbereich gezeigt. Die mit "BCB" bezeichneten Kurven beziehen sich auf eine Streifenleitung, deren Dielektrikum 3 aus einer BCB-Schicht bestand. Die mit "PP" bezeichneten Kurven beziehen sich auf eine erfindungsgemässe Streifenleitung, deren Dielektrikum 3 aus einem Polypropylenfilm bestand. Die Schichtdicken d beider Dielektrika 3 (bzw. dielektrischer Schichtsysteme) sowie die Signalleiterbreite w und die Metallisicrungsdicke t waren vergleichbar. Im Detail waren d(PP) = 57 µm, d(BCB) = 54 µm, w = 31 µm und t = 0,5 µm. Aus den oberen beiden Kurven, die sich auf die rechte Abszisse beziehen, ist der Verlauf der effektiven, relativen Dielektrizitätskonstante ε_{r,eff} über einen Frequenzbereich von 30 bis 480 GHz ersichtlich. Man erkennt deutlich, dass die effektive dielektrische Konstante der BCB-Leitung über den gesamten Frequenzbereich deutlich über der effektiven dielektrischen Konstante des Polypropylenwellenleiters liegt. Im ersteren Fall beträgt die effektive dielektrische Konstante 2,05 bis etwa 2,1 über den gesamten Frequenzbereich, im letztgenannten Fall beträgt die effektive dielektrische Konstante 1,85 bis 1,91 über den gesamten Frequenzbereich.

Aus der tieferliegenden Kurvenschar ergibt sich der Verlauf der Dämpfung α beider Streifenleitungen, wobei die Bezeichnungsweise wie zuvor gewählt wurde. Im Falle des auf einer BCB-Schicht basierenden Streifenleiters beträgt die gemessene Dämpfung minimal 0,2 dB/mm und steigt für hohe Frequenzen auf bis zu 2 dB/mm an. Dagegen beträgt die Dämpfung der erfindungsgemässen Streifenleitung, basierend auf einem Polypropylenfilm, minimal etwa 0,09 dB / mm und steigt zum oberen Ende des Frequenzbereichs auf maximal 0,8 dB / mm an. Dieses vorteilhafte Resultat der erfindungsgemässen Streifenleitung ist einerseits Resultat der vorteilhaften dielektrischen Eigenschaften von Polypropylen, andererseits auch Ausdruck der Tatsache, dass die erfindungsgemässen Streifenleiter mit hervorragender Genauigkeit bezüglich des Abstands von metallischer Grundelektrode 1 zu metallischen Signalleiter 2 erstellt werden können.

Zum Aufkleben des einseitig selbstbeschichteten Dielektrikums 3 hat sich das folgende Verfahren besonders bewährt. Das bandförmige Dielektrikum 3 wird mittels der Selbstklebeschicht 31 auf einer kleinen Kontaktfläche mit der metallischen Grundelektrode 1 verklebt. Von dieser ausgehend wird das Dielektrikum 3 mittels einer Walze 51 ohne Einschluss von Luftblasen oder Staub auf die metallische Grundelektrode 1 aufgewalzt. Vorteilhaft geschieht dies mit einer Vorrichtung, welche einerseits eine Abrollvorrichtung 52 für das bandförmige Dielektrikum enthält, und andererseits eine Walze 51, vorzugsweise Gummiwalze, die insbesondere angefeuchtet werden kann und die zum Aufwalzen des Dielektrikums auf die Grundelektrode 1 dient. Insbesondere kann vorgesehen werden, mittels geeigneter Hilfsrollen 53 und geeigneter Anordnung von Abrollvorrichtung 52 und Walze 51 zueinander einen definierten Winkel zwischen bandförmigem Dielektrikum 3 und metallischer Grundelektrode 1 während des Aufrollvorgangs einzustellen. Ein Griff 54 sorgt für gute Handhabbarkeit. Weiterhin ist eine Abdeckung 55 vorgesehen, die für Staubschutz sorgt. Eine derartige Vorrichtung ist in Figur 4 gezeigt. Auf diese Weise können Bedienungsfehler beim Aufkleben des Dielektrikums weitgehend ausgeschlossen werden.

## Patentansprüche

1. Streifenleitung für Hochfrequenzanwendungen, bestehend aus einer metallischen Grundelektrode (1), einem metallischen Signalleiter (2) und einem zwischen Grundelektrode (1) und Signalleiter (2) angeordneten Dielektrikum (31), **dadurch gekennzeichnet, dass** das Dielektrikum (31) aus einem relaxierten, insbesondere vorgereckten Polymerfilm besteht, der einseitig mit einer Selbstklebeschicht (32) beschichtet ist.

2. Streifenleitung gemäss Anspruch 1, **dadurch gekennzeichnet, dass** das Dielektrikum (31), insbesondere aber das dielektrische Schichtsystem bestehend aus Dielektrikum (31) und Selbstklebeschicht (32), im Frequenzbereich zwischen500 MHz und 1 THz, insbesondere im Frequenzbereich zwischen 1 GHz und 500 GHz eine relative Dielektrizitätskonstante εᵣ von kleiner als 2,5 aufweist.

3. Streifenleitung gemäss Anspruch 1, **dadurch gekennzeichnet, dass** die mittlere Dicke d des Dielektrikums (31), insbesondere aber des dielektrischen Schichtsystems (3) aus Dielektrikum (31) und Selbstklebeschicht (32) im Intervall [5 µm, 100 µm] liegt, wobei sie vorzugsweise 50 µm beträgt.

4. Streifenleitung gemäss Anspruch 1, **dadurch gekennzeichnet, dass** die Dickenschwankungen δd des Dielektrikums (31), insbesondere aber des dielektrischen Schichtsystems (3) aus Dielektrikum (31) und Selbstklebeschicht (32) in Abschnitten der Streifenleitung mit konstanter mittlerer Dicke d kleiner sind als 5%, vorzugsweise kleiner sind als 2% und insbesondere kleiner sind als 1% der mittleren Dicke d.

5. Streifenleitung gemäss Anspruch 1, **dadurch gekennzeichnet, dass** das Dielektrikum (31) aus Polypropylen besteht.

6. Streifenleitung gemäss Anspruch 1, **dadurch gekennzeichnet, dass** die Selbstklebeschicht (32) aus Acrylat-Copolymer besteht.

7. Streifenleitung gemäss Anspruch 1, **dadurch gekennzeichnet, dass** die metallische Grundelektrode (1) und/oder der metallische Signalleiter (2) thermisch oder mittels Elektronenstrahlverdampfung aufgedampft, galvanisch abgeschieden oder aufgesputtert ist.

8. Streifenleitung gemäss Anspruch 1, **dadurch gekennzeichnet, dass** die metallische Grundelektrode (1) und/oder der metallische Signalleiter (2) aus einer selbstklebend beschichteten Metallfolie besteht.

9. Streifenleitung gemäss Anspruch 1, **dadurch gekennzeichnet, dass** der metallische Signalleiter (2) und/oder die Grundelektrode (1) mittels gängiger Lithographietechniken strukturiert ist.

10. Streifenleitung gemäss Anspruch 1, **dadurch gekennzeichnet, dass** die Form des Dielektrikums (31) gemäss der Substratform vorkonfektioniert ist.

11. Streifenleitung gemäss Anspruch 1, **dadurch gekennzeichnet, dass** die Streifenleitung ein passives Hochfrequenzbauelement wie einen Leitungsknick, eine Leiterbreitenstufe, einen Leitungsleerlauf, einen Leitungskurzschluss, einen Filter oder eine Antenne bildet.

## Claims

1. A microstrip line for high frequency applications consisting of a metallic ground electrode (1), a metallic signal conductor (2) and a dielectric (31) arranged between ground electrode (1) and signal conductor (2), wherein the dielectric (31) consists of a relaxed, more specifically pre-stretched, polymer film that is coated on one side with a self-adhesive layer (32).

2. The microstrip line according to claim 1, wherein the dielectric (31), but more specifically the stacked dielectric system consisting of dielectric (31) and self-adhesive layer (32), has a relative permittivity εᵣ of less than 2.5 in the frequency range between 500 MHz and 1 THz, more specifically in the frequency range between 1 GHz and 500 GHz.

3. The microstrip line according to claim 1, wherein the mean thickness d of the dielectric (31), but more specifically of the stacked dielectric system (3) consisting of dielectric (31) and self-adhesive layer (32), lies between [5 µm, 100 µm], preferably amounting to 50 µm.

4. The microstrip line according to claim 1, wherein the variations in thickness δd of the dielectric (31), but more specifically of the stacked dielectric system (3) consisting of the dielectric (31) and of the self-adhesive layer (32) provided in portions of the microstrip line with a constant mean thickness d, are less than 5 %, preferably less than 2 % and more specifically less than 1 % of the mean thickness d.

5. The microstrip line according to claim 1, wherein the dielectric (31) is made from polypropylene.

6. The microstrip line according to claim 1, wherein the self-adhesive layer (32) is made from acrylate copolymer.

7. The microstrip line according to claim 1, wherein the metallic ground electrode (1) and/or the metallic signal conductor (2) are deposited either by thermal vaporization or by means of electron-beam evaporation, by electrolytic deposition or by sputtering.

8. The microstrip line according to claim 1, wherein the metallic ground electrode (1) and/or the metallic signal conductor (2) consist of a metal film coated with a self-adhesive layer.

9. The microstrip line according to claim 1, wherein the metallic signal conductor (2) and/or the ground electrode (1) are structured by means of current lithographic techniques.

10. The microstrip line according to claim 1, wherein the shape of the dielectric (31) is prefabricated according to the shape of the substrate.

11. The microstrip line according to claim 1, wherein the microstrip line forms a passive high-frequency component part such as for example a kink in a line, a width graduation in a line, a device to open circuit a line, a device to short circuit a line, a filter or an antenna.

## Revendications

1. Microbande destinée à des applications haute fréquence, se composant d'une électrode métallique de base (1), d'un conducteur métallique de signaux (2) et d'un diélectrique (31) disposé entre l'électrode de base (1) et le conducteur de signaux (2), **caractérisée par le fait que** le diélectrique (31) se compose d'un film polymère relaxé, en particulier pré-étiré, qui est revêtu d'un côté d'une couche auto-adhésive (32).

2. Microbande selon la revendication 1, **caractérisée par le fait que** le diélectrique (31), mais en particulier le système diélectrique en couches se composant du diélectrique (31) et de la couche auto-adhésive (32), présente dans la gamme des fréquences comprise entre 500 MHz et 1 THz, en particulier dans la gamme des fréquences comprise entre 1 GHz et 500 GHz, une permittivité relative εᵣ inférieure à 2,5.

3. Microbande selon la revendication 1, **caractérisée par le fait que** l'épaisseur moyenne d du diélectrique (31), mais en particulier du système diélectrique en couches (3) se composant du diélectrique (31) et de la couche auto-adhésive (32), est située dans l'intervalle [5 µm, 100 µm], de préférence elle étant de 50 µm.

4. Microbande selon la revendication 1, **caractérisée par le fait que** les variations d'épaisseur δd du diélectrique (31), mais en particulier du système diélectrique en couches (3) se composant du diélectrique (31) et de la couche auto-adhésive (32), dans des tronçons de la microbande avec une épaisseur constante moyenne d sont inférieures à 5 %, de préférence inférieures à 2 % et en particulier inférieures à 1 % de l'épaisseur moyenne d.

5. Microbande selon la revendication 1, **caractérisée par le fait que** le diélectrique (31) se compose de polypropylène.

6. Microbande selon la revendication 1, **caractérisée par le fait que** la couche auto-adhésive (32) se compose de copolymère acrylate.

7. Microbande selon la revendication 1, **caractérisée par le fait que** l'électrode métallique de base (1) et/ou le conducteur métallique de signaux (2) est ou bien sont déposé(e)(s) par vaporisation thermique ou au moyen de l'évaporation par faisceau électronique, par galvanisation ou par pulvérisation (sputtering).

8. Microbande selon la revendication 1, **caractérisée par le fait que** l'électrode métallique de base (1) et/ou le conducteur métallique de signaux (2) se compose(nt) d'une feuille métallique revêtue d'une couche auto-adhésive.

9. Microbande selon la revendication 1, **caractérisée par le fait que** le conducteur métallique de signaux (2) et/ou l'électrode de base (1) est ou bien sont structuré(e)(s) au moyen de techniques courantes de lithographie.

10. Microbande selon la revendication 1, **caractérisée par le fait que** la forme du diélectrique (31) est pré-confectionnée suivant la forme du substrat.

11. Microbande selon la revendication 1, **caractérisée par le fait que** la microbande forme un composant passif haute fréquence tel qu'un coude de ligne, un gradin de largeur du conducteur, un circuit ouvert de ligne, un court-circuit de ligne, un filtre ou une antenne.
